# EUROPEAN PATENT APPLICATION

(11) **EP 3 726 589 A1**
(43) Date of publication of application: **21.10.2020**
(21) Application number: 20168447.9
(22) Date of filing: 07.04.2020
(51) Int. Cl.: H01L 31/02, B64G 1/44, H01L 31/05, H01L 31/0475

(54) **SINGLE TOE INTERCONNECT**

(30) Priority: 19.04.2019 US 201916389643
(71) Applicant: The Boeing Company, Chicago, IL 60606-1596 (US)
(72) Inventor: Hebert, Peter, Chicago, IL 60606-1596 (US); Chiu, Philip T., Chicago, IL 60606-1596 (US)
(74) Representative: Witte, Weller & Partner Patentanwälte mbB

(57) **Abstract**

An interconnect for making electrical connections for a solar cell, wherein the interconnect consists of a single toe, without a second toe connected to the single toe, and with no connected crossbars. A plurality of the interconnects may be placed uniformly across an edge of the solar cell. In one example, three interconnects are placed uniformly across an edge of the solar cell, when the solar cell has an area less than 60 cm². In another example, four or more interconnects are placed uniformly across an edge of the solar cell, when the solar cell has an area greater than 60 cm².

## Description

### BACKGROUND INFORMATION

### 1. Field.

The disclosure is related generally to a single toe interconnect for solar cells.

### 2. Background.

In order to make use of electrical power generated by solar cells from sunlight, the current must be transported from the solar cell to the external circuit. This is typically done using metal gridlines (fine features collecting current from all areas of the device), one or more busbars (larger feature aggregating current from many gridlines), contact pads (locations to attach tabs/interconnects to connect to other devices), and interconnects to span between the contact pads and other devices. These grids, busbars, contact pads, tabs and interconnects all result in parasitic losses.

The metal used for grids, busbars, contact pads and interconnects also imposes power losses on the solar cell's conversion efficiency, by preventing light from reaching the semiconductor layers of the solar cell, from parasitic losses, and with series resistance. For state-of-the-art space solar cells, metal coverage of the solar cell is the primary loss factor. Optimization of gridlines and busbar designs is standard practice to reduce obscuration, but the design and location of contacts and interconnects has received little attention.

Space solar cells typically have two or three interconnects spaced as widely apart as possible. This common practice is intended to reduce the risk of an open circuit if a solar cell cracks, but also results in current flowing relatively long distances along the busbars. Removal of an interconnect for large-format solar cells is known to cause efficiency loss. For example, the most recent evolution has been to reduce interconnects from three to two for all solar cells with an area less than 65 cm², with the remaining two interconnects being placed as widely apart as possible.

However, widely spaced interconnects increase resistance losses when conducting current to the interconnects and/or result in increased dimensions of the busbars that reduces cell current. Moreover, widely spaced interconnects increase the risk that cell cracks could isolate all interconnects, creating on open circuit. In addition, interconnects only being available in multiples of two leads to over- or under-designed solutions.

Thus, there is a need in the art for improved solar cell interconnects. The present disclosure satisfies this need.

### SUMMARY

To overcome the limitations described above, and to overcome other limitations that will become apparent upon reading and understanding the present specification, the present disclosure describes an interconnect for making electrical connections for a solar cell, wherein the interconnect consists of a single toe, without a second toe connected to the single toe, and with no connected crossbars. The present disclosure also describes a method for fabricating the interconnect and a method for making electrical connections using the interconnect.

The interconnect is comprised of one or more layers of conductive, bondable material, selected from aluminum (Al), copper (Cu), silver (Ag), gold (Au), molybdenum (Mo), Kovar® (an iron-nickel-cobalt alloy), Invar (64FeNi), or an alloy or combination thereof. The interconnect is about 0.25 to 1 inch in length, 40 to 100 mils in width, and 1 to 2 mils in thickness.

A plurality of the interconnects may be placed uniformly across an edge of the solar cell. In one example, three interconnects are placed uniformly across an edge of the solar cell, when the solar cell has an area less than 60 cm². In another example, four or more interconnects are placed uniformly across an edge of the solar cell, when the solar cell has an area greater than 60 cm².

### DRAWINGS

Referring now to the drawings in which like reference numbers represent corresponding parts throughout:
FIG. 1A illustrates a typical solar cell and the interconnects used to transmit electrical power generated by the solar cell.
FIG. 1B illustrates a typical configuration for one interconnect.
FIG. 2A shows an interconnect consisting of a single toe, without a second toe and with no crossbars.
FIG. 2B illustrates the placement of four interconnects along one edge of a solar cell.
FIG. 2C illustrates the placement of five interconnects along one edge of a solar cell.
FIG. 3 is a graph of relative power loss (i.e., resistance loss, obscuration, and total power loss) for a solar cell with different numbers and types of interconnects.
FIG. 4A illustrates a method of fabricating a solar cell, solar cell panel and/or satellite.
FIG. 4B illustrates a resulting satellite having a solar cell panel comprised of solar cells.
FIG. 5 is an illustration of the solar cell panel in the form of a functional block diagram.

### DETAILED DESCRIPTION

In the following description, reference is made to the accompanying drawings which form a part hereof, and in which is shown by way of illustration a specific example in which the disclosure may be practiced. It is to be understood that other examples may be utilized and structural changes may be made without departing from the scope of the present disclosure.

### Overview

This disclosure improves electrical connections between solar cells by replacing relatively fewer, large interconnects with relatively more, smaller interconnects. Currently, space-grade interconnects are comprised of two parallel flat metal "toes" or "legs" connected with crossbars. In this disclosure, an interconnect consists of a single flat metal toe, without a second toe, and with no connected crossbars.

Making interconnects with only a single toe allows the number of interconnects to be properly sized to the cell and program, including odd numbers of interconnects. Removing the crossbars allows interconnects to be placed more uniformly across the solar cell's edges, increasing solar cell efficiency, reducing material cost, improving reliability and enabling advanced manufacturing, such as real-time laser cutting of interconnects.

### Technical Description

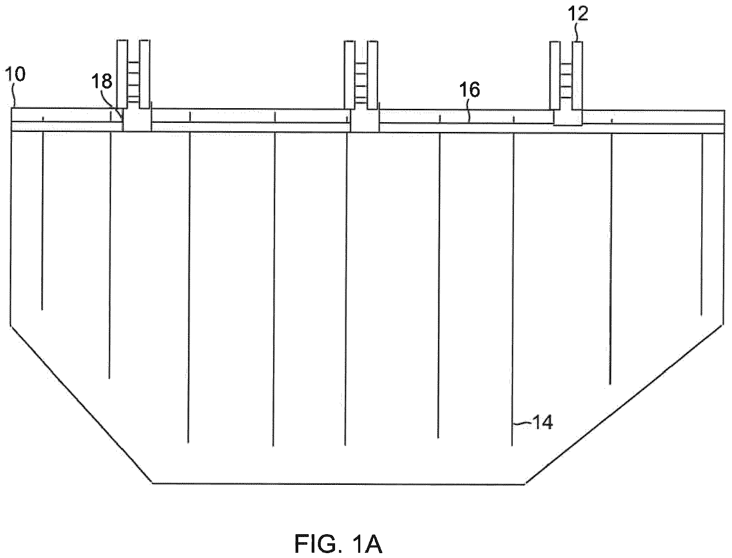

FIG. 1A illustrates a solar cell 10 and the interconnects 12 used to transmit the electrical power generated by the solar cell 10. The solar cell 10 includes metal gridlines 14 collecting current from all areas of the solar cell 10, one or more busbars 16 aggregating current from the gridlines 14, contact pads 18 used to attach the interconnects 12 to span between the contact pads 18 and other devices (not shown).

As shown in FIG. 1A, space solar cells 10 typically have 2 or 3 interconnects 12 spaced as widely apart as possible. This common practice is intended to reduce the risk of an open circuit if a solar cell cracks, but also results in current flowing relatively long distances along the busbar 16. However, customers have been known to remove an interconnect 12 for large-format cells 10, which is known to cause efficiency losses.

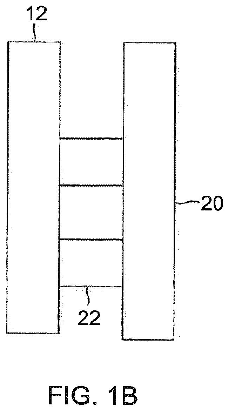

FIG. 1B illustrates a configuration for one interconnect 12. The interconnect 12 is comprised of two thin flat metal toes or legs 20 positioned in parallel with two or more crossbars 22 holding the two toes 20 in place. The need to provide weld redundancy is why double toes 20 are used.

The limitations of this configuration include:
- The crossbars 22 require the double toes 20 to be closely spaced, which has disadvantages, namely, mechanical stress is concentrated at the toes 20, and placing two toes 20 close together increases stress concentration factors.
- The use of crossbars 22 increases the width of material required to make each interconnect 12.
- Widely spaced interconnects 12 increase resistance losses of conducting current to the interconnects 12 and/or result in increased dimensions of the busbars 16, which reduces cell current.
- Widely spaced interconnects 12 increase the risk that solar cell 10 cracks could isolate all interconnects 12, creating on open circuit.
- Interconnects 12 only being available in multiples of two leads to over-designed or under-designed solutions.

As noted above, metal coverage of the solar cell 10 is the primary loss factor. Gridlines 14 and busbars 16 have been optimized to reduce obscuration, but interconnects 12 have received little attention.

This disclosure overcomes these limitations by providing a new design for an improved interconnect with a single toe or leg, and distributing the interconnects relatively uniformly across an edge of the solar cell.

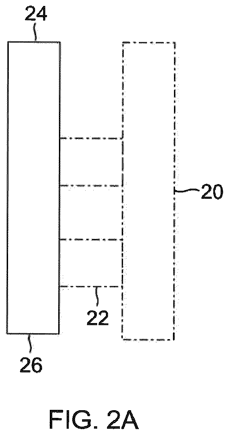

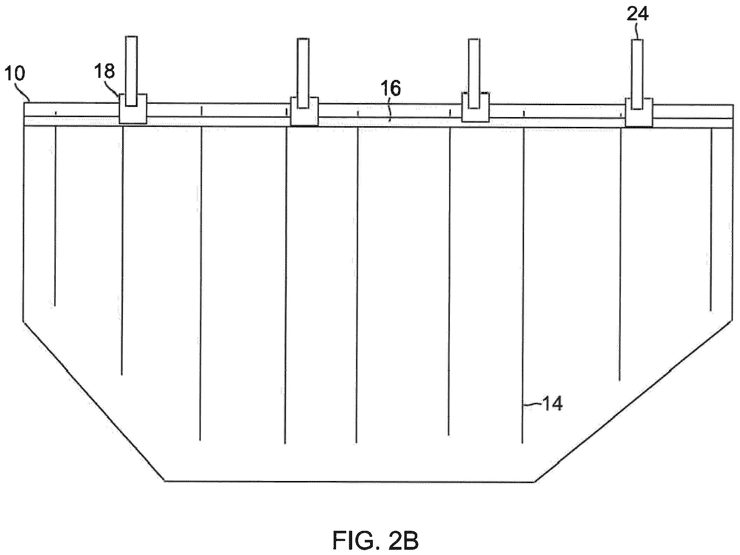

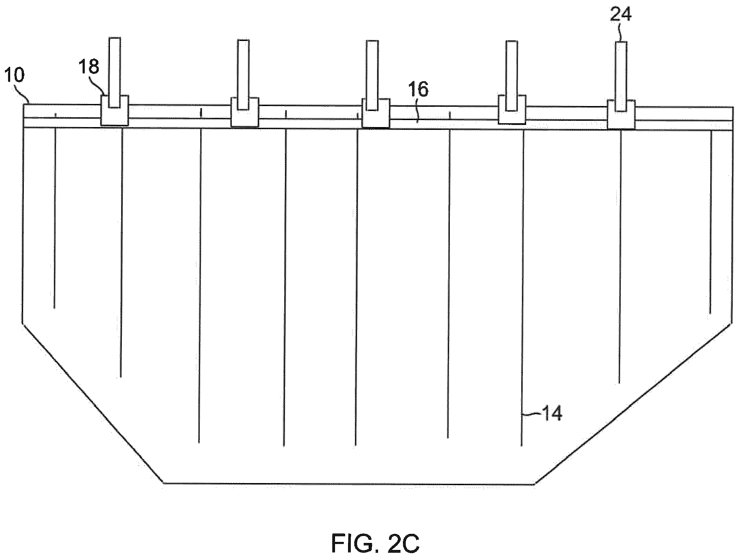

An apparatus, method of fabricating and method of making electrical connections using this new design are illustrated in FIGS. 2A, 2B and 2C, wherein FIG. 2A shows an interconnect 24 for making electrical connections for the solar cell 10, the interconnect 24 consisting of a single toe 26, without a second toe 20 connected to the single toe 26, and with no connected crossbars 22; FIG. 2B illustrates a plurality, i.e., four, of the interconnects 24 placed uniformly along an edge of the solar cell 10; and FIG. 2C illustrates a plurality, i.e., five, of the interconnects 24 placed uniformly along an edge of the solar cell 10.

In one example, the interconnect 24 is comprised of one or more layers of conductive, bondable material, for example, in the form of a metal foil, selected from aluminum (Al), copper (Cu), silver (Ag), gold (Au), molybdenum (Mo), Kovar® (an iron-nickel-cobalt alloy), Invar (64FeNi), or an alloy, or combination thereof. The interconnect 24 may be about 0.25 to 1 inch in length, 40 to 100 mils in width, and 1 to 2 mils in thickness.

In one example, the plurality of the interconnects comprise three interconnects 24 placed uniformly, i.e., with equal space between each interconnect 24, across an edge of the solar cell 10, when the solar cell 10 has an area less than 60 cm². In another example, the plurality of the interconnects 24 comprise four or more interconnects 24 placed uniformly across an edge of the solar cell 10, when the solar cell 10 has an area greater than 60 cm².

This interconnect 24 reduces both current and voltage losses in the busbars 16, while reducing assembly attrition and maintaining risk mitigation against open circuits. The result is improved efficiency, reduced parasitic loss, and improved manufacturability by eliminating the double toe interconnects 12 with connected crossbars 22.

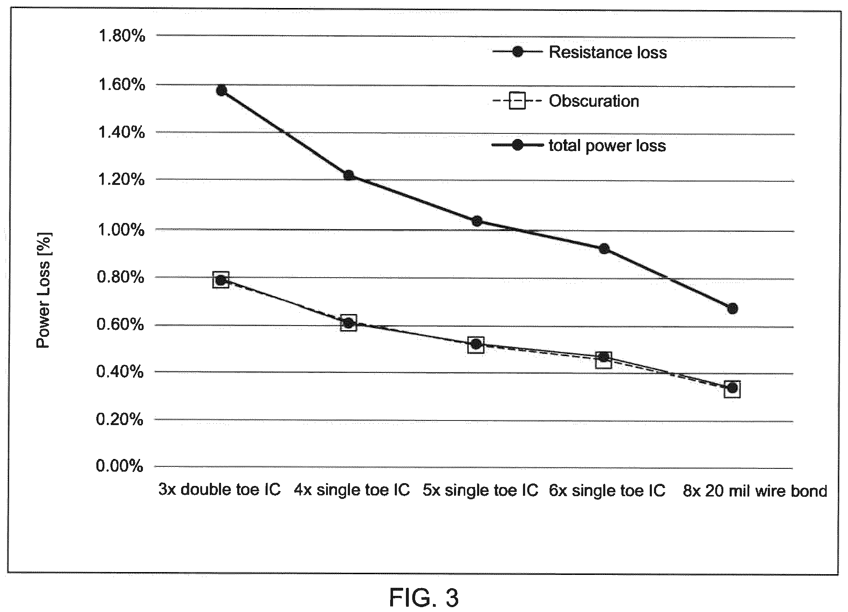

FIG. 3 is a graph of relative power loss (i.e., resistance loss, obscuration, and total power loss) for a solar cell 10 with an area greater than 70 cm² with different numbers and types of interconnects (lower power loss is better), including a 3x double toe interconnect (IC) 12, 4x single toe IC 24, 5x single toe IC 24, 6x single toe IC 24, and 8x 20 mil wire bond.

From an operational efficiency perspective, there are reasons one might not look to this solution of a single toe interconnect 24. For example, the reduced metal used for the interconnect 24 may increase the potential for damage.

However, use of the single toe interconnects 24 between solar cells 10 provides a number of benefits, including increased redundancy, reduced assembly attrition, more flexible design options, increased reliability, improved efficiency, reduced material cost, and advanced manufacturing.

For example, the number of interconnections can be increased using the single toe interconnects 24 to increase redundancy. Alternatively, the number of interconnections using the single toe interconnects 24 can be decreased to reduce assembly attrition.

This disclosure provides more flexible design options, in that the solar cell 10 can have more points of interconnection (more redundancy) or fewer points of interconnection (reduced assembly attrition) using the new interconnects 24.

Specifically, by removing the crossbar 22 between double toes 20, this disclosure provides more design freedom to select the number of interconnections and the location of those interconnections using the new interconnects 24. For example, odd numbers of interconnections for the solar cell 10 are possible using the interconnects 24, whereas the interconnects 12 always result in even numbers of interconnections due to the double toes 20.

This disclosure can provide equal, greater, or less reliability than currently required as determined by the number, spacing and/or locations of interconnects 24. For example, the number, spacing and locations of the interconnections can be selected to improve solar cell 10 efficiency (evenly spaced) or positioned based on some other constraints. Specifically, the location of interconnections using the interconnects 24 are not constrained by the crossbars 22.

Removing the crossbars 22 allows the interconnects 24 to be placed more uniformly across the edges of the solar cell 10, which simultaneously increases solar cell 10 efficiency, reduces material cost, and improves reliability. For example, even spacing of interconnects 24 leads to improved reliability by reducing the probability that solar cell 10 cracks can electrically isolate the interconnects 24 to create an open circuit. Even spacing of interconnects 24 also leads to higher solar cell 10 efficiency due to reduced busbar 16 obscuration and resistance losses.

Single toe interconnects 24 inherently reduce the amount of material consumed in fabrication and therefore the cost of the interconnect 24. The crossbars 22 increase material consumption and cost of interconnects 12, and increases obscuration for contact pads 18 on a solar cell 10. Single toe interconnects 24 are more compatible with advanced manufacturing concepts, such as real-time laser cutting of the interconnects 24 from raw stock material. Single-toe interconnects 24 also provide mechanical stress relief for the solar cell 10.

### Fabrication

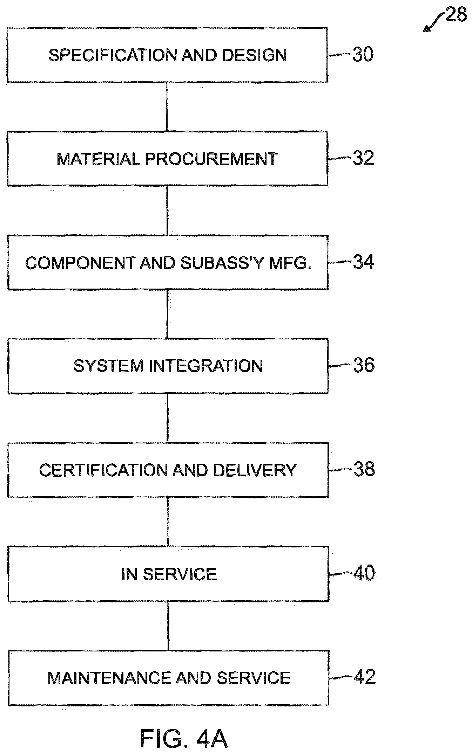

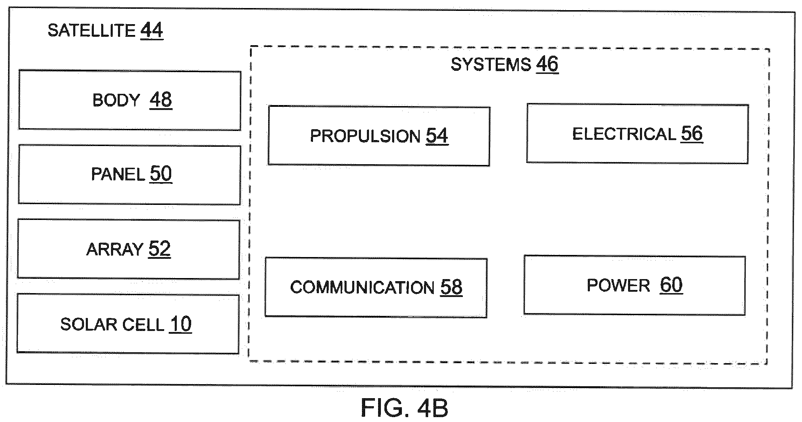

Examples of the disclosure may be described in the context of a method 28 of fabricating one or more interconnects 24, a solar cell 10 using the interconnects 24, a solar cell panel comprised of the solar cells 10, and/or a space vehicle such as a satellite including the solar cell panel, comprising steps 30-42, as shown in FIG. 4A, wherein the resulting satellite 44 comprised of various systems 46 and a body 48, including a panel 50 comprised of an array 52 of one or more solar cells 10 is shown in FIG. 4B.

As illustrated in FIG. 4A, during pre-production, exemplary method 28 may include specification and design 30 of the satellite 44, and material procurement 32 for same. During production, component and subassembly manufacturing 34 and system integration 36 of the satellite 44 takes place, which include fabricating the satellite 44, panel 50, array 52 and solar cells 10. Thereafter, the satellite 44 may go through certification and delivery 38 in order to be placed in service 40. The satellite 44 may also be scheduled for maintenance and service 42 (which includes modification, reconfiguration, refurbishment, and so on), before being launched.

Each of the processes of method 28 may be performed or carried out by a system integrator, a third party, and/or an operator (e.g., a customer). For the purposes of this description, a system integrator may include without limitation any number of manufacturers and major-system subcontractors; a third party may include without limitation any number of venders, subcontractors, and suppliers; and an operator may be a satellite company, military entity, service organization, and so on.

As shown in FIG. 4B, the satellite 44 fabricated by exemplary method 28 may include various systems 46 and a body 48. Examples of the systems 46 included with the satellite 44 include, but are not limited to, one or more of a propulsion system 54, an electrical system 56, a communications system 58, and a power system 60. Any number of other systems also may be included.

### Functional Block Diagram

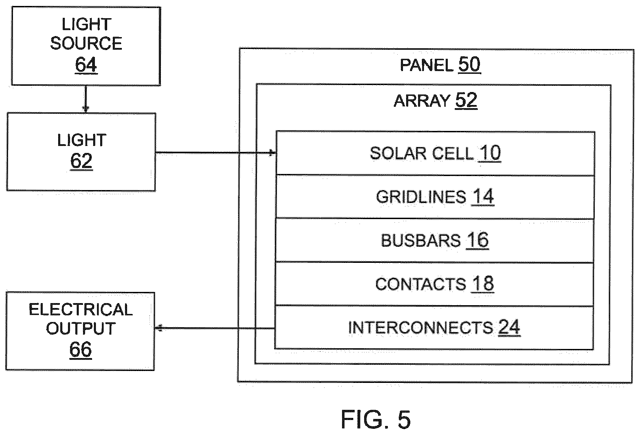

FIG. 5 is an illustration of the panel 50 in the form of a functional block diagram, according to one example. The panel 50 is comprised of the array 52, which is comprised of one or more of the solar cells 10 individually attached to the panel 50. Each of the solar cells 10 absorbs light 62 from a light source 64 and generates an electrical output 66 in response thereto.

At least one of the solar cells 10 includes at least the metal gridlines 14 collecting current from all areas of the solar cell 10, the busbars 16 aggregating current from the gridlines 14, and contact pads 18 used to attach the interconnects 24 to span between the contact pads 18 and other devices (not shown) for making electrical connections.

Further, the disclosure comprises examples according to the following clauses:
Clause 1. An apparatus, comprising: one or more interconnects for making electrical connections, each of the interconnects consisting of a single toe, without a second toe connected to the single toe, and with no connected crossbars.
Clause 2. The apparatus of Clause 1, wherein each of the interconnects is comprised of one or more layers of conductive, bondable material, selected from aluminum (Al), copper (Cu), silver (Ag), gold (Au), molybdenum (Mo), Kovar® (an iron-nickel-cobalt alloy), Invar (64FeNi), or an alloy or combination thereof.
Clause 3. The apparatus of Clause 1 or 2, wherein each of the interconnects is about 0.25 to 1 inch in length, 40 to 100 mils in width, and 1 to 2 mils in thickness.
Clause 4. The apparatus of any of Clauses 1-3, wherein the interconnects make the electrical connections for a solar cell.
Clause 5. The apparatus of Clause 4, wherein a plurality of the interconnects are placed uniformly across an edge of the solar cell.
Clause 6. The apparatus of Clause 5, wherein the plurality of the interconnects comprise three interconnects placed uniformly across an edge of the solar cell, and the solar cell has an area less than 60 cm².
Clause 7. The apparatus of Clause 5, wherein the plurality of the interconnects comprise four or more interconnects placed uniformly across an edge of the solar cell, and the solar cell has an area greater than 60 cm².
Clause 8. A method, comprising: fabricating one or more interconnects for making electrical connections, each of the interconnects consisting of a single toe, without a second toe connected to the single toe, and with no connected crossbars.
Clause 9. The method of Clause 8, wherein each of the interconnects is comprised of one or more layers of conductive, bondable material, selected from aluminum (Al), copper (Cu), silver (Ag), gold (Au), molybdenum (Mo), Kovar® (an iron-nickel-cobalt alloy), Invar (64FeNi), or an alloy or combination thereof.
Clause 10. The method of Clause 8 or 9, wherein each of the interconnects is about 0.25 to 1 inch in length, 40 to 100 mils in width, and 1 to 2 mils in thickness.
Clause 11. The method of any of Clauses 8-10, wherein the interconnects make the electrical connections for a solar cell.
Clause 12. The method of Clause 11, wherein a plurality of the interconnects are placed uniformly across an edge of the solar cell.
Clause 13. The method of Clause 12, wherein the plurality of the interconnects comprise three interconnects placed uniformly across an edge of the solar cell, and the solar cell has an area less than 60 cm².
Clause 14. The method of Clause 12, wherein the plurality of the interconnects comprise four or more interconnects placed uniformly across an edge of the solar cell, and the solar cell has an area greater than 60 cm².
Clause 15. A method, comprising: making electrical connections to one or more solar cells using one or more interconnects, each of the interconnects consisting of a single toe, without a second toe connected to the single toe, and with no connected crossbars.
Clause 16. The method of Clause 15, further comprising making the electrical connections to the one or more solar cells in a panel comprised of an array of the one or more solar cells.
Clause 17. The method of Clause 16, further comprising making the electrical connections to the one or more solar cells in a space vehicle including the panel.
Clause 18. An apparatus, comprising: one or more solar cells; and one or more interconnects for making electrical connections to the solar cells, each of the interconnects consisting of a single toe, without a second toe connected to the single toe, and with no connected crossbars.
Clause 19. The apparatus of Clause 18, wherein the one or more interconnects comprise three interconnects placed uniformly across an edge of one of the solar cells having an area less than 60 cm².
Clause 20. The apparatus of Clause 18 or 19, wherein the one or more interconnects comprise four or more interconnects placed uniformly across an edge of one of the solar cells having an area greater than 60 cm².
Clause 21. The apparatus of any of Clauses 18-20, further comprising a panel comprised of an array of the solar cells.
Clause 22. The apparatus of Clause 21, further comprising a space vehicle including the panel.

## Claims

1. An apparatus, comprising:
one or more interconnects (24) for making electrical connections, each of the interconnects (24) consisting of a single toe (26), without a second toe (20) connected to the single toe (26), and with no connected crossbars (22).

2. The apparatus of claim 1, wherein each of the interconnects (24) is comprised of one or more layers of conductive, bondable material, selected from aluminum (Al), copper (Cu), silver (Ag), gold (Au), molybdenum (Mo), an iron-nickel-cobalt alloy, Invar (64FeNi), or an alloy or combination thereof.

3. The apparatus of claim 1 or 2, wherein each of the interconnects (24) is about 0.25 to 1 inch in length, 40 to 100 mils in width, and 1 to 2 mils in thickness.

4. The apparatus of any one of claims 1-3, wherein the interconnects (24) make the electrical connections for a solar cell (10).

5. The apparatus of claim 4, wherein a plurality of the interconnects (24) are placed uniformly across an edge of the solar cell (10), wherein the plurality of the interconnects (24) preferably comprise three interconnects (24) placed uniformly across an edge of the solar cell (10), and the solar cell (10) has an area less than 60 cm² or wherein the plurality of the interconnects (24) preferably comprise four or more interconnects (24) placed uniformly across an edge of the solar cell (10), and the solar cell (10) has an area greater than 60 cm².

6. A method, comprising:
fabricating one or more interconnects (24) for making electrical connections, each of the interconnects (24) consisting of a single toe (26), without a second toe (20) connected to the single toe (26), and with no connected crossbars (22).

7. The method of claim 6, wherein each of the interconnects (24) is comprised of one or more layers of conductive, bondable material, selected from aluminum (Al), copper (Cu), silver (Ag), gold (Au), molybdenum (Mo), an iron-nickel-cobalt alloy, Invar (64FeNi), or an alloy or combination thereof.

8. The method of claim 6 or 7, wherein each of the interconnects (24) is about 0.25 to 1 inch in length, 40 to 100 mils in width, and 1 to 2 mils in thickness.

9. The method of any of claims 6-8, wherein the interconnects (24) make the electrical connections for a solar cell (10).

10. The method of claim 9, wherein a plurality of the interconnects (24) are placed uniformly across an edge of the solar cell (10), wherein the plurality of the interconnects (24) preferably comprise three interconnects (24) placed uniformly across an edge of the solar cell (10), and the has an area less than 60 cm² or wherein the plurality of the interconnects (24) preferably comprise four or more interconnects (24) placed uniformly across an edge of the solar cell (10), and the solar cell (10) has an area greater than 60 cm².

11. A method, comprising:
making electrical connections to one or more solar cells (10) using one or more interconnects (24), each of the interconnects (24) consisting of a single toe (26), without a second toe (20) connected to the single toe (26), and with no connected crossbars (22).

12. The method of claim 11, further comprising making the electrical connections to the one or more solar cells (10) in a panel (50) comprised of an array (52) of the one or more solar cells (10), the method optionally further comprising making the electrical connections to the one or more solar cells (10) in a space vehicle including the panel (50).

13. An apparatus, comprising:
one or more solar cells (10); and
one or more interconnects (24) for making electrical connections to the solar cells (10), each of the interconnects (24) consisting of a single toe (26), without a second toe (20) connected to the single toe (26), and with no connected crossbars (22).

14. The apparatus of claim 13, wherein the one or more interconnects (24) comprise three interconnects (24) placed uniformly across an edge of one of the solar cells (10) having an area less than 60 cm² or wherein the one or more interconnects (24) comprise four or more interconnects (24) placed uniformly across an edge of one of the solar cells (10) having an area greater than 60 cm².

15. The apparatus of claim 14, further comprising a panel (50) comprised of an array (52) of the solar cells (10), the apparatus optionally further comprising a space vehicle including the panel (50).
